## Europäisches Patentamt
## European Patent Office
## Office européen des brevets

(11) Publication number: **0 107 415**
**B1**

# EUROPEAN PATENT SPECIFICATION

(45) Date of publication of patent specification: **04.01.89**

(51) Int. Cl.⁴: **G 11 C 11/40**, G 11 C 7/00

(21) Application number: **83305970.2**

(22) Date of filing: **30.09.83**

(54) **A static memory circuit.**

(30) Priority: **30.09.82 JP 172152/82**

(43) Date of publication of application:
**02.05.84 Bulletin 84/18**

(45) Publication of the grant of the patent:
**04.01.89 Bulletin 89/01**

(84) Designated Contracting States:
**DE FR GB**

(56) References cited:
**EP-A-0 043 245**

(73) Proprietor: **FUJITSU LIMITED**
**1015, Kamikodanaka Nakahara-ku**
**Kawasaki-shi Kanagawa 211 (JP)**

(72) Inventor: **Noguchi, Eiji**
**2-10-3, Wakabadai Shiroyamamachi**
**Tsukui-gun Kanagawa 220-01 (JP)**
Inventor: **Aoyama, Keizo**
**11-28, Tsukimino 1-chome**
**Yamato-shi Kanagawa 242 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

## Description

The present invention relates to static memory circuitry.

Recently, to increase the speed of a reading operation in memory circuitry, a technique has been employed in which, before accessing a memory cell, a pair of bit lines connected therewith are reset to a predetermined potential, such as an intermediate potential between a high (H) level and a low (L) level. This shortens the transition time of the bit-line potentials to the desired H level or the L level during a reading operation. In this technique, the bit-line potentials must be completely reset before raising the potential of the selected word line.

In conventional static memory circuitry, such as disclosed in EP—A—0 043 245, the reset of a bit-line potential is carried out immediately after the change of an input address signal, as described later in detail. However, improvements in high speed operation of static memory circuitry have increasingly shortened the period from when the input address signal changes to when the word line potential begins to rise. Because of this, the potential of the word line often rises before completion of resetting of the bit-line potentials. In these circumstances, data stored in a memory cell connected to the selected pair of bit lines can be destroyed, or the reading operation can be delayed.

Accordingly, it is desirable to provide static memory circuitry which can perform a high speed reading operation without destruction of data stored in the memory cells thereof.

According to the present invention there is provided static memory circuitry comprising:

a plurality of memory cells arranged in a matrix having columns and rows;

a plurality of word lines connected to respective rows of the said memory cells;

row selection means, connected to the said word lines, for applying a selection signal to any one of the said word lines that is indicated individually by a row address signal applied to the row selection means;

a plurality of pairs of bit lines connected to respective columns of the said memory cells; and

resetting means, including reset signal generating means operable, in response to a change in the said row address signal at the start of a cell accessing operation, to produce a reset signal which is employed to bring about a bit line equalization operation in which the respective potentials of the bit lines of at least one of the said pairs are equalized;

characterised by delay means, included in the said resetting means, for delaying production of the said reset signal by a predetermined length of time, longer than the period of time required to complete the said cell accessing operation, from the instant of the said change in the row address signal, the circuitry being such that the said reset signal is terminated in response to the first row address signal change to occur after expiry of the said predetermined length of time, leaving the bit line potentials reset for the purposes of the next cell accessing operation.

Static memory circuitry having the features given in that portion of the preceding paragraph before the words "characterised by" was disclosed, for example, in EP—A—0 043 245.

Reference will now be made, by way of example, to the accompanying drawings, wherein:

Figure 1 shows static memory circuitry embodying the present invention;

Fig. 2 shows waveforms used for explaining problems of conventional static memory circuitry;

Fig. 3 shows waveforms used for explaining the operation of the circuitry of Fig. 1;

Fig. 4 shows waveforms used for explaining the operation of further static memory circuitry embodying the present invention;

Fig. 5 shows logic circuitry forming part of the above-mentioned further static memory circuitry;

Fig. 6 shows waveforms used for explaining a write operation of static memory circuitry embodying the present invention; and

Fig. 7 shows logic circuitry employed during a write operation illustrated in Fig. 6.

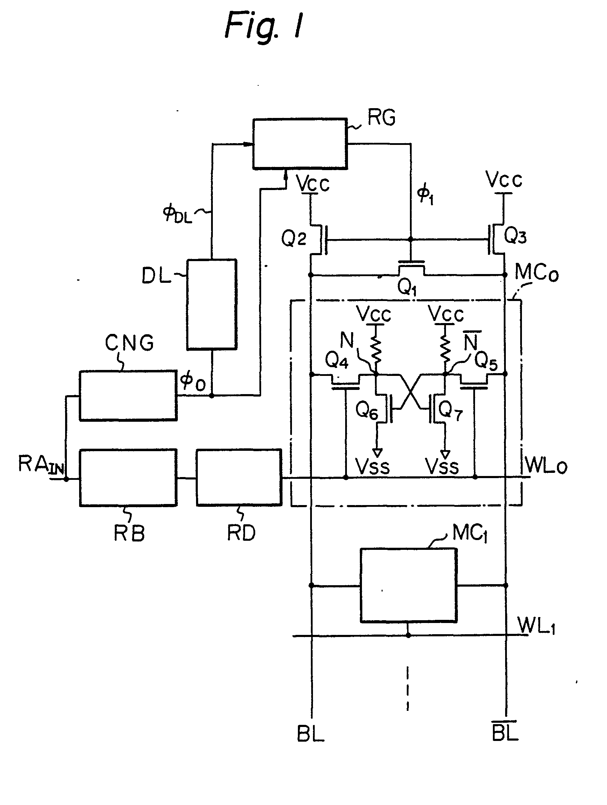

A first embodiment of the present invention will now be described with reference to Fig. 1, in which $MC_0$ is a memory cell arranged at the cross point of a pair of bit lines BL and $\overline{BL}$ and a word line $WL_0$; $MC_1$ is another memory cell arranged at the cross point of the same bit lines and a word line $WL_1$; RB is a row address buffer for receiving a row address signal $RA_{IN}$; RD a row decoder for selecting the word line $WL_0$ in response to the row address signal $RA_{IN}$ output from the row address buffer RB; and CNG an address-change detecting circuit for detecting a change in the potential of the row address signal to generate an address change detecting signal $\phi_0$. A delay circuit DL and a reset signal generating circuit RG are further provided in this embodiment. The delay circuit DL generates a delay signal $\phi_{DL}$ the rise of which is delayed from the rise of the address change detecting signal $\phi_0$, output from the address change detecting circuit CNG, by a time equal to one accessing period. The reset pulse generator circuit RG receives the delay signal $\phi_{DL}$ from the delay circuit DL and the address change detecting signal $\phi_0$ from the address change detecting circuit CNG and provides a first reset signal $\phi_1$ which rises to an H level before a change of the row address signal $RA_{IN}$.

At one end of the pair of bit lines BL and $\overline{BL}$, a bit line resetting transistor $Q_1$, having a source and a drain connected between the bit lines BL and $\overline{BL}$, and bit line precharging transistors $Q_2$ and $Q_3$, having respective sources and drains connected between the end of the bit line BL or $\overline{BL}$ and a high voltage terminal $V_{cc}$ of a power supply, are provided. The first reset signal $\phi_1$, output from the reset signal generating circuit RG, is applied to the gates of the transistors $Q_1$, $Q_2$ and $Q_3$.

The memory cell $MC_0$ has two transfer gate

transistors $Q_4$ and $Q_5$, and two memory storage transistors $Q_6$ and $Q_7$ which are cross-coupled to one another and constitute a flip-flop.

While only two memory cells $MC_0$ and $MC_1$ are illustrated in Fig. 1, as is well known, in a static memory circuit, there are a number of memory cells having the same structure arranged in a matrix of columns and rows. Each of the word lines is connected to all of the memory cells in a corresponding row of memory cells, and each of the bit line pairs is connected to all of the memory cells in a corresponding column of memory cells.

In conventional static memory circuitry (not shown), a delay circuit DL and a reset signal generating circuit RG of a type embodying the present invention are not provided. Also, the address change detecting signal $\phi_0$, output from the address change detecting circuit CNG (Fig. 1), is used as a reset signal, or, alternatively, a signal $\phi$, which is obtained by changing the pulse width of the pulse $\phi_0$ as required, is used as a reset signal. That is, in the prior art, all of the bit lines are reset immediately after a change of a row address signal.

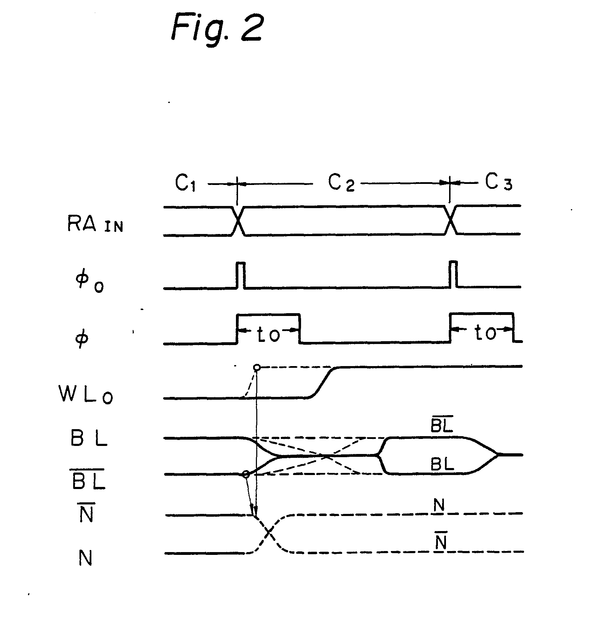

Problems arising in conventional static memory circuitry of the type described in the preceding paragraph will be described with reference to Fig. 2. As illustrated in Fig. 2, the conventional reset signal $\phi$ rises in response to the rise of the address change detecting signal $\phi_0$, which is formed in response to a change in a row address signal $RA_{IN}$, and the conventional reset signal $\phi$ falls after a period $t_0$ from its rise, the period $t_0$ being a period necessary for resetting the bit lines BL and $\overline{BL}$.

A conventional normal reading operation will now be described with reference to the solid curves in Fig. 2. When the conventional reset signal $\phi$ is applied to the gates of the transistors $Q_1$, $Q_2$ and $Q_3$, these transistors are turned on, so that the potentials of the bit lines BL and $\overline{BL}$ are reset to an intermediate level between the H level and the L level. After this, when the row decoder selects the word line $WL_0$ to raise its potential to the H level, the potential of one of the bit lines, BL or $\overline{BL}$, changes from the intermediate level to the H level and the potential of the other of the bit lines, $\overline{BL}$ or BL, changes from the intermediate level to the L level, in accordance with the data stored in the memory cell $MC_0$. Since the potentials of the bit lines BL and $\overline{BL}$ have previously been reset to the intermediate level, the above-mentioned transitions of the potential of the bit lines BL and $\overline{BL}$ are effected within a relatively short time, in comparison with the case where both of the bit lines BL and $\overline{BL}$ have been precharged to the H level, i.e. the power supply voltage $V_{cc}$, and where the transition of the potential of one of the bit lines must be effected always from the H level to the L level.

However, as illustrated by the broken curves in Fig. 2, problems can occur when the potential of the word line $WL_0$ rises before the fall of the conventional reset signal $\phi$ or a short period after the rise of the conventional reset signal $\phi$.

Assume that a memory cell other than the memory cell $MC_0$, for example $MC_1$, connected between the bit lines BL and $\overline{BL}$, stores data which is different to the data stored in the memory cell $MC_0$. As a result of a reading operation for the above-mentioned memory cell in a previous reading cycle $C_1$, the potential of the bit line BL is assumed to be the H level and the potential of the bit line $\overline{BL}$ is assumed to be the L level. Since the memory cell $MC_0$ is assumed to store data different to that in the above-mentioned memory cell which was read in the previous cycle $C_1$, a node N of the memory cell $MC_0$, which node is the point of connection between the source of the transistor $Q_4$, the drain of the transistor $Q_6$, and the gate of the transistor $Q_7$, is at the L level, and a node $\overline{N}$ of the memory cell $MC_0$, which node is the point of connection between the source of the transistor $Q_5$, the drain of the transistor $Q_7$, and the gate of the transistor $Q_6$, is at the H level. In a current reading cycle $C_2$, the memory cell $MC_1$ is assumed to be accessed. If the potential of the bit lines BL and $\overline{BL}$ has not been reset before the potential of the word line $WL_0$ rises, the potential of the bit line $\overline{BL}$ is kept at the L level, which is set during the previous reading cycle $C_1$. Therefore, charges on the node $\overline{N}$ are discharged through the transistor $Q_5$. Thus, the potential of the node $\overline{N}$ may be turned to the L level when the transistor $Q_5$ is turned on by raising the potential of the word line $WL_0$, resulting in data destruction in the memory cell $MC_0$. After the data is destroyed, the bit lines BL and $\overline{BL}$ are erroneously kept at the H level and the L level, respectively.

Even when the data in the memory cell $MC_0$ is not destroyed, a high speed reading operation cannot be effected because the bit lines BL and $\overline{BL}$ are not reset before the potential of the word line $WL_0$ is raised. Therefore, the rising and the falling of the bit lines BL and $\overline{BL}$ are delayed.

Recent technology has shortened the period from the change of the input address signal to the rise of the word line potential, and it is difficult to reset the bit lines within such a shortened period.

According to an embodiment of the present invention, a reset signal for the next reading cycle is generated before a change of a row address signal $RA_{IN}$, thereby enabling the afore-mentioned problems of the prior art to be avoided.

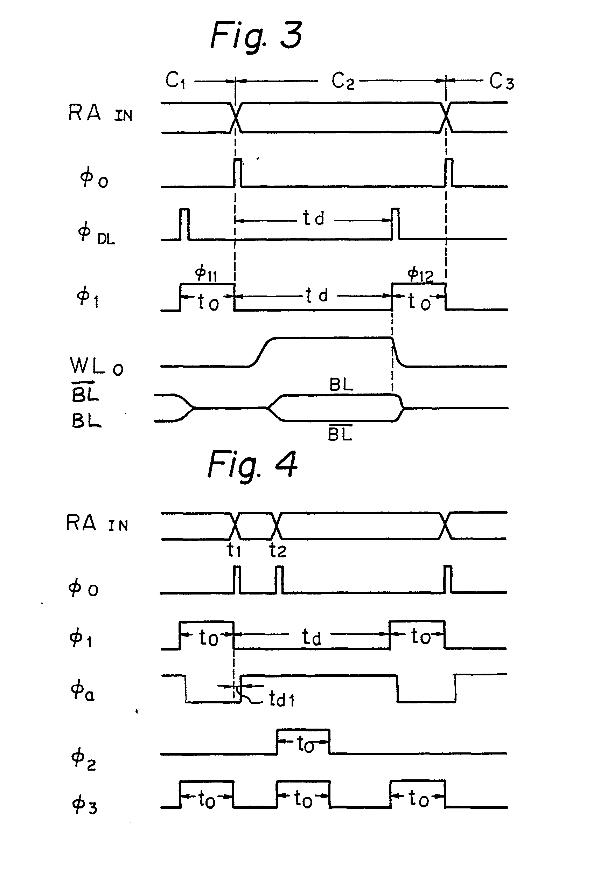

Figure 3 is a waveform diagram for explaining the operation of the circuit of Fig. 1. The delay circuit DL of Fig. 1 produces the delay signal $\phi_{DL}$, which is generated after a delay time $t_d$ from the generation of the address change detecting signal $\phi_0$ output from the address change detecting circuit CNG. The delay time $t_d$ is set to be longer than a period necessary for accessing a memory cell. The reset signal generating circuit RG generates the first reset signal $\phi_1$, which rises in response to the rise of the delay signal $\phi_{DL}$ and falls in response to the rise of the address change detecting signal $\phi_0$. Accordingly, the first reset signal $\phi_1$ rises after the time $t_d$ from a change of the row address signal $RA_{IN}$ and falls in response to the next change of the row address signal $RA_{IN}$.

In Fig. 3, two reset signal pulses $\phi_{11}$ and $\phi_{12}$ are illustrated. The reset signal pulse $\phi_{11}$, which is generated at the end of the previous reading cycle $C_1$, is used for resetting the bit lines BL and $\overline{BL}$ to an intermediate level potential between the H level and the L level, for the purpose of carrying out a reading operation during the current reading cycle $C_2$. The reset signal pulse $\phi_{12}$, which is generated at the end of the current reading cycle $C_2$, is used for resetting the bit lines BL and $\overline{BL}$ to an intermediate level potential, for the purpose of carrying out a reading operation during the next reading cycle $C_3$. Therefore, however fast the word line $WL_0$ rises in the current reading cycle $C_2$, the bit lines BL and $\overline{BL}$ have already been reset before the word line $WL_0$ rises. Accordingly, the data stored in the memory cell $MC_0$ is not destroyed and is read out to the bit lines BL and $\overline{BL}$ by rapidly changing the potential thereof to the H level or to the L level in accordance with the stored data. The data read out on the bit lines BL and $\overline{BL}$ is latched into a sense amplifier (not shown) connected thereto. After the latch of the data, the bit lines BL and $\overline{BL}$ are reset again for the next reading cycle. The latching technique itself is not the subject-matter of the present invention and was described in Japanese Patent Application No. 57—50098 by the same applicant (corresponding to US Serial No. 478,722).

The duration of the first reset signal pulse $\phi_{11}$, $\phi_{12}$ is determined so as to sufficiently reset the bit lines BL and $\overline{BL}$.

The delay circuit DL may be constructed by a plurality of inverters connected in series to generate the delay signal $\phi_{DL}$ or may be constructed by a dummy circuit which operates with the same timing clocks as those of the circuit operation in the static memory circuitry.

The structure of the address change detecting circuit CNG is also disclosed in the aforementioned Japanese Patent Application No. 57—50098.

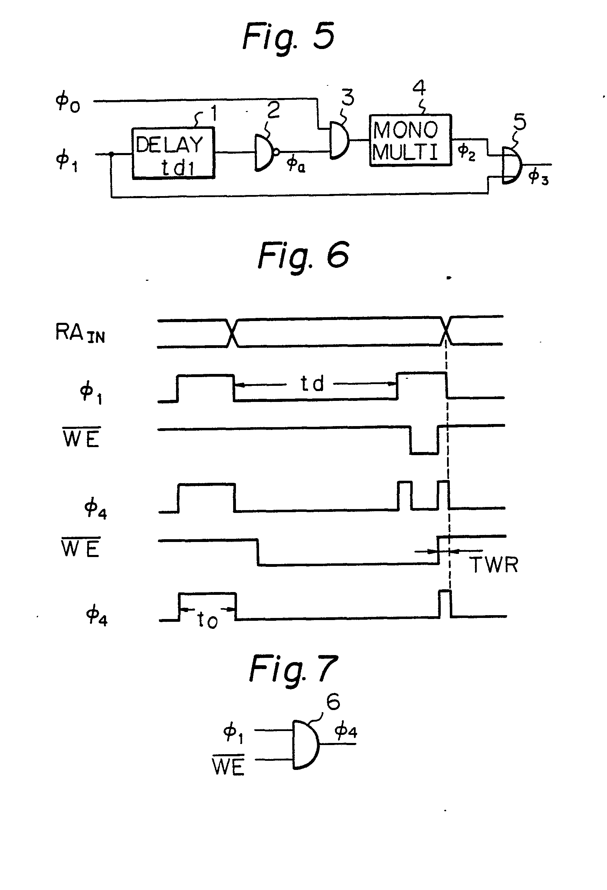

A second embodiment of the present invention will now be described with reference to Figs. 4 and 5. As shown in Fig. 4, there is a possibility that, shortly after a change of the row address signal $RA_{IN}$ at a time $t_1$, the row address signal $RA_{IN}$ again changes at a time $t_2$. The time $t_2$ is later than the time $t_1$, but the period between the times $t_1$ and $t_2$ is shorter than the delay time $t_d$. In this case, the circuit of Fig. 1 cannot generate the first reset signal $\phi_1$ between the times $t_1$ and $t_2$. Such a possibility of two or more changes of the row address signal within a period shorter than the minimum accessing period may occur, for example, when the row address signals of two rows are generated at slightly different times.

To reset the bit line potential in response to such an abnormal change of a row address signal as mentioned above, additional signals $\phi_a$, $\phi_2$ and $\phi_3$ are generated in accordance with the second embodiment of the present invention.

These signals are generated in a logic circuit shown in Fig. 5. Referring to Figs. 4 and 5, an additional delay circuit 1 delays the first reset signal $\phi_1$ by a small delay period $t_{d1}$. An inverter 2 inverts the output of the additional delay circuit 1 to provide an inverted signal $\phi_a$. The address change detecting signal $\phi_0$ and the inverted signal $\phi_a$ are input to an AND gate 3. A monostable multivibrator 4 receives the output of the AND gate 3 and outputs a second (additional) reset signal pulse $\phi_2$ which has a time duration $t_0$ sufficient for resetting the bit lines BL and $\overline{BL}$. The first reset signal $\phi_1$ and the second reset signal $\phi_2$ are input to an OR gate 5. At the output of the OR gate 5, a third reset signal $\phi_3$ including the first reset signal $\phi_1$ and the second reset signal $\phi_2$ is obtained.

The third reset signal $\phi_3$ is applied to the gates of the transistors $Q_1$, $Q_2$ and $Q_3$ (Fig. 1). Thus, a reset signal is generated not only for a normal address change which occurs after a sufficiently long period for accessing a memory cell after the previous address change, but also for an abnormal address change which occurs immediately after the previous address change as shown in Fig. 4.

The second reset signal $\phi_2$ is generated immediately after the abnormal address change at the time $t_2$ in the same way as the conventional reset signal $\phi$ (Fig. 2) is generated. Therefore, the same problems may arise for the second reset signal $\phi_2$. However, in most cases in static memory circuitry, for an abnormal address change, i.e. for an address change which occurs within a period shorter than the delay time $t_d$, the time necessary for accessing a memory cell is set to be longer than that for a normal address change. When the accessing time for an abnormal address change is set to be so long, the potential of the word line rises slowly, so that no data destruction occurs.

As a result, according to the second embodiment of the present invention shown in Figs. 4 and 5, the effect of the first embodiment is also obtained for normal address changes which occur a long period after the previous address changes. For abnormal address changes which occur in a period shorter than the accessing period after the previous address changes, the bit lines are reset in the same way as they are conventionally.

In the circuit of Fig. 1, there is a possibility that the writing characteristic may deteriorate or that a writing operation cannot be carried out while the reset signal is at the H level. To -avoid this problem, as shown in Fig. 6, the first reset signal $\phi_1$ is inhibited while a write enable signal $\overline{WE}$ is at the L level, i.e. during a writing operation. To inhibit the first reset signal $\phi_1$, as shown in Fig. 7, a fourth (auxiliary) reset signal $\phi_4$ is obtained by gating the first reset signal $\phi_1$ and the write enable signal $\overline{WE}$ through an AND gate 6. The fourth reset signal $\phi_4$ is applied to the gates of the transistors $Q_1$, $Q_2$ and $Q_3$ in Fig. 1. Thus, the detrimental influence of the reset signal on the writing characteristic can be prevented.

It is clear that, instead of the first reset signal $\phi_1$, the second reset signal $\phi_2$ may alternatively be applied to the AND gate 6.

If, however, as illustrated in Fig. 6, the width of the L level of the write enable signal $\overline{WE}$ during one active cycle is longer than the delay time $t_d$, the width of the fourth reset signal pulse $\phi_4$ is narrower than the duration $t_0$. However, in static memory circuitry, the width of the H level of the write enable signal $\overline{WE}$ immediately before a change of an address signal is generally set to be a value greater than a predetermined value TWR. Therefore, the width of the fourth reset signal pulse $\phi_4$ is at least TWR.

As has been described, according to an embodiment of the present invention, by generating a reset signal for a next active cycle before changing an address signal for the next active cycle, bit lines in static memory circuity can be reliably reset, regardless of how fast the word line rises after the change of the address signal in the next active cycle. This can result in a high speed reading operation without destruction of data stored in memory cells of the circuitry.

## Claims

1. Static memory circuitry comprising:

a plurality of memory cells ($MC_0$, $MC_1$, ...) arranged in a matrix having columns and rows;

a plurality of word lines ($WL_0$, $WL_1$, ...) connected to respective rows of the said memory cells;

row selection means (RB, RD), connected to the said word lines, for applying a selection signal to any one of the said word lines that is indicated individually by a row address signal ($RA_{IN}$) applied to the row selection means;

a plurality of pairs of bit lines (BL, $\overline{BL}$) connected to respective columns of the said memory cells; and

resetting means (CNG, DL, RG, $Q_1$, $Q_2$, $Q_3$), including reset signal generating means (RG) operable, in response to a change in the said row address signal ($RA_{IN}$) at the start of a cell accessing operation, to produce a reset signal ($\phi_{12}$) which is employed to bring about a bit line equalization operation in which the respective potentials of the bit lines (BL, $\overline{BL}$) of at least one of the said pairs are equalized;

characterised by delay means (DL), included in the said resetting means, for delaying production of the said reset signal ($\phi_{12}$) by a predetermined length of time ($t_d$), longer than the period of time required to complete the said cell accessing operation, from the instant of the said change in the row address signal ($RA_{IN}$), the circuitry being such that the said reset signal ($\phi_{12}$) is terminated in response to the first row address signal change to occur after expiry of the said predetermined length of time, leaving the bit line potentials reset for the purposes of the next cell accessing operation.

2. Circuitry as claimed in claim 1, wherein the said resetting means (CNG, DL, RG, $Q_1$, $Q_2$, $Q_3$) further comprise an address change detecting circuit (CNG) operable to detect a change in a row address signal ($RA_{IN}$) and to produce an address change detecting signal ($\phi_0$) in response to such a change, the said address change detecting signal ($\phi_0$) being supplied to the said delay means (DL) which are operable, upon the elapse of the said predetermined length of time from receipt of said address change detecting signal ($\phi_0$), to produce a delay signal ($\phi_{DL}$) for delivery to the said reset signal generating means (RG), upon receipt of which the said reset signal generating means (RG) produce the said reset signal ($\phi_{12}$).

3. Circuitry as claimed in claim 1 or 2, wherein the said resetting means (CNG, DL, RG, $Q_1$, $Q_2$, $Q_3$) further comprise additional reset signal generating means (1, 2, 3, 4) operable, in response to any row address signal change which occurs whilst production of the said reset signal ($\phi_{12}$) is delayed, to produce an additional reset signal ($\phi_2$) which is employed to bring about a bit line equalization operation.

4. Circuitry as claimed in claim 3, wherein the said additional reset signal generating means (1, 2, 3, 4) comprise additional delay means (1) connected to receive the said reset signal ($\phi_{12}$) and operable to supply that signal, after a predetermined time delay ($t_{d1}$), to inverting means (2), included in the said additional reset signal generating means (1, 2, 3, 4), which inverting means (2) are operable to invert the delayed reset signal ($\phi_{12}$); and

an AND gate (3) connected to receive the inverted reset signal ($\phi_a$) and the said address change detecting signal ($\phi_0$) and operable to provide an output signal for delivery to a monostable multivibrator (4), included in the said additional reset signal generating means (1, 2, 3, 4), which multivibrator (4) is operable, upon receipt of the said output signal, to produce the said additional reset signal ($\phi_2$).

5. Circuitry as claimed in any preceding claim, wherein, when a write enable signal ($\overline{WE}$) is applied to the circuitry during a writing operation, the said resetting means (CNG, DL, RG, $Q_1$, $Q_2$, $Q_3$) are operable to produce an auxiliary reset signal ($\phi_4$) which is employed to bring about a bit line equalization operation.

6. Circuitry as claimed in claim 5, wherein the said resetting means (CNG, DL, RG, $Q_1$, $Q_2$, $Q_3$) further comprise an AND gate (6) connected to receive the said write enable signal ($\overline{WE}$) and either the said reset signal ($\phi_{12}$) or the said additional reset signal ($\phi_2$), and operable to provide an output signal which forms the said auxiliary reset signal ($\phi_4$).

7. Circuitry as claimed in any preceding claim, wherein the said resetting means (CNG, DL, RG, $Q_1$, $Q_2$, $Q_3$) further comprise a plurality of bit line resetting transistors ($Q_1$), each of which has a load current path, connected between the bit lines (BL, $\overline{BL}$) of a corresponding pair of bit lines, and a control terminal connected to receive an activating signal.

8. Circuitry as claimed in claim 7, wherein the said resetting means (CNG, DL, RG, $Q_1$, $Q_2$, $Q_3$) further comprise bit line precharging transistors ($Q_2$, $Q_3$), each having a load current path connected between an end of a corresponding one of the said bit lines (BL, $\overline{BL}$) and an output terminal of a power supply, and also having a control terminal connected to receive the said activating signal.

9. Circuitry as claimed in claim 7 or 8, when read as appended to claim 1 or 2, wherein the said activating signal is the said reset signal ($\phi_{12}$).

10. Circuitry as claimed in claim 7 or 8, when read as appended to claim 3 or 4, wherein the said activating signal is a combination of the said reset signal ($\phi_{12}$) with the said additional reset signal ($\phi_2$).

11. Circuitry as claimed in claim 7 or 8, when read as appended to claim 5 or 6, wherein the said activating signal is the said auxiliary reset signal ($\phi_4$).

**Patentansprüche**

1. Statische Speicherschaltung mit:
einer Vielzahl von Speicherzellen ($MC_0$, $MC_1$, ...), die in einer Matrix angeordnet sind, welche Spalten und Reihen hat;
einer Vielzahl von Wortleitungen ($WL_0$, $WL_1$, ...), die mit entsprechenden Reihen der genannten Speicherzellen verbunden sind;
Reihenauswahleinrichtungen (RB, RD), die mit den genannten Wortleitungen verbunden sind, um ein Auswahlsignal auf irgendeine der genannten Wortleitungen aufzubringen, die individuell durch ein Reihenadreßsignal ($RA_{IN}$), welches der Reihenauswahleinrichtung zugeführt wird, angezeigt ist;
einer Vielzahl von Paaren von Bitleitungen (BL, $\overline{BL}$), die mit jeweiligen Spalten der genannten, Speicherzellen verbunden sind; und
Rücksetzeinrichtungen (CNG, DL, RG, $Q_1$, $Q_2$, $Q_3$), die eine Rücksetzsignal-Generatoreinrichtung (RG) enthalten, die betreibbar ist, um, in Abhängigkeit von einer Änderung in dem genannten Reihenadreßsignals ($RA_{IN}$) an dem Beginn einer Zellenzugriffsoperation, ein Rücksetzsignal ($\phi_{12}$) zu erzeugen, welches dazu verwendet wird, einen Bitleitungsausgleichsbetrieb herbeizuführen, bei dem die jeweiligen Potentiale der Bitleitungen (BL, $\overline{BL}$) von wenigstens einem der genannten Paare ausgeglichen werden,
gekennzeichnet durch Verzögerungseinrichtungen (DL) die in der genannten Rücksetzeinrichtung, enthalten sind, um die Erzeugung des genannten Rücksetzsignals ($\phi_{12}$), von dem Augenblick der genannten Änderung in dem Reihenadreßsignal ($RA_{IN}$), um eine vorbestimmte Zeitlänge ($t_d$) zu Verzögern, welche länger als die Zeitperiode ist, die zur vervollständigung des genannten Zellenzugriffsbetriebs erforderlich ist, welche Schaltung derart ist, daß das genannte Rücksetzsignal ($\phi_{12}$) beendet wird, in Abhängigkeit von der ersten Reihenadreßsignaländerung, die nach Ablauf der genannten vorbestimmten Zeitlänge auftritt, wobei die Bitleitungspotentiale für den Zweck der nächsten Zellenzugriffsoperation zurückgesetzt gelassen werden.

2. Schaltung nach Anspruch 1, bei der die genannten Rücksetzeinrichtungen (CNG, DL, RG, $Q_1$, $Q_2$, $Q_3$) ferner eine Adreßänderungs-Detektionsschaltung (CNG) umfassen, die betreibbar ist, um eine Änderung in einem Reihenadreßsignal ($RA_{IN}$) zu detektieren, und um ein Adreßänderungs-Detektionssignal ($\phi_0$) in Abhängigkeit von solch einer Änderung zu erzeugen, welches genannte Adreßänderungs-Detektionssignal ($\phi_0$) der genannten Verzögerungseinrichtung (DL) zugeführt wird, die betreibbar ist, um nach Ablauf der genanten vorbestimmten Zeitlänge von dem Empfang des genannten Adreßänderungs-Detektionssignals ($\phi_0$) ein Verzögerungssignal ($\phi_{DL}$) zu erzeugen, zur Lieferung an die genannte Rücksetzsignal-Generatoreinrichtung (RG), auf dessen Empfang hin die genannte Rücksetzsignal-Generatoreinrichtung (RG) das genannte Rücksetzsignal ($\phi_{12}$) erzeugt.

3. Schaltung nach Anspruch 1 oder 2, bei der die genannten Rücksetzeinrichtungen (CNG, DL, RG, $Q_1$, $Q_2$, $Q_3$) ferner eine zusätzliche Rücksetzsignal-Generatoreinrichtung (1, 2, 3, 4) umfassen, die betreibbar ist, in Abhängigkeit von irgendeiner Reihenadreßsignaländerung, die auftritt, während die Erzeugung des genannten Rücksetzsignals ($\phi_{12}$) verzögert wird, um ein zusätzliches Rücksetzsignal ($\phi_2$) zu erzeugen, welches dazu verwendet wird, den Bitleitungsausgleichsbetrieb herbeizuführen.

4. Schaltung nach Anspruch 3, bei der die genannte Rücksetzsignal-Generatoreinrichtung (1, 2, 3, 4) eine zusätzliche Verzögerungseinrichtung (1) umfaßt, die angeschlossen ist, um das genannte Rücksetzsignal ($\phi_{12}$) zu empfangen, und betreibbar ist, um jenes Signal nach einer vorbestimmten Zeitverzögerung ($t_{d1}$), an die invertierende Einrichtung (2) zu liefern, die in der genannten zusätzlichen Rücksetzsignal-Generatoreinrichtung (1, 2, 3, 4) enthalten ist, welche invertierende Einrichtung betreibbar ist, um das verzögerte Rücksetzsignal ($\phi_{12}$) zu invertieren; und
ein UND-Gatter (3), welches angeschlossen ist, um das invertierte Rücksetzsignal ($\phi_a$) und das genannte Adressänderungs-Detektionssignal ($\phi_0$) zu empfangen, und betreibbar ist, um ein Ausgangssignal vorzusehen, zur Lieferung an einen monostabilen Multivibrator (4), der in der genannten zusätzlichen Rücksetzsignal-Generatoreinrichtung (1, 2, 3, 4) enthalten ist, welcher Multivibrator (4) betreibbar ist, bei Empfang des genannten Ausgangssignals, um das genannte zusätzliche Rücksetzsignal ($\phi_2$) zu erzeugen.

5. Schaltung nach einem der vorhergehenden Ansprüche, bei der, wenn das Schreibfreigabesignal ($\overline{WE}$) der Schaltung während des Schreibbetriebs zugeführt wird, die genannten Rücksetzeinrichtungen (CNG, DL, RG, $Q_1$, $Q_2$, $Q_3$) betreibbar sind, um ein Hilfsrücksetzsignal ($\phi_4$) zu erzeugen, welches verwendet wird, einen Bitleitungsausgleichsbetrieb herbeizuführen.

6. Schaltung nach Anspruch 5, bei der die genannten Rücksetzeinrichtungen (CNG, DL, RG, $Q_1$, $Q_2$, $Q_3$) ferner ein UND-Gatter (6) umfassen, das angeschlossen ist, um das genannte Schreibfreigabesignal ($\overline{WE}$) und entweder das genannte Rücksetzsignal ($\phi_{12}$) oder das genannte zusätzli-

che Rücksetzsignal ($\phi_2$) zu empfangen, und betreibbar ist, um ein Ausgangssignal vorzusehen, welches das genannte Hilfsrücksetzsignal ($\phi_4$) bildet.

7. Schaltung nach einem der vorhergehenden Ansprüche, bei der die genannten Rücksetzeinrichtungen (CNG, DL, RG, $Q_1$, $Q_2$, $Q_3$) ferner eine Vielzahl von Bitleitungs-Rücksetztransistoren ($Q_1$) umfassen, von denen jeder einen Laststromweg hat, der zwischen den Bitleitungen (BL, $\overline{\text{BL}}$) eines entsprechenden Paares von Bitleitungen angeschlossen ist, und einen Steueranschluß, der zum Empfang eines aktivierenden Signals angeschlossen ist.

8. Schaltung nach Anspruch 7, bei der die genannten Rücksetzeinrichtungen (CNG, DL, RG, $Q_1$, $Q_2$, $Q_3$) ferner Bitleitungs-Vorladetransistoren ($Q_2$, $Q_3$) umfassen, von denen jeder einen Laststromweg hat, der zwischen einem Ende einer entsprechenden der genannten Bitleitungen (BL, $\overline{\text{BL}}$) und einem Ausgangsanschluß einer Energieversorgung angeschlossen ist, und auch einen Steueranschluß hat, der angeschlossen ist, um das genannte aktivierende Signal zu empfangen.

9. Schaltung nach Anspruch 7 oder 8, in Verbindung mit Anspruch 1 oder 2, bei der das genannte aktivierende Signal das genannte Rücksetzsignal ($\phi_{12}$) ist.

10. Schaltung nach Anspruch 7 oder 8, in Verbindung mit Anspruch 3 oder 4, bei der das genannte aktivierende Signal eine Kombination des genannten Rücksetzsignals ($\phi_{12}$) mit dem zusätzlichen Rücksetzsignal ($\phi_2$) ist.

11. Schaltung nach Anspruch 7 oder 8, in Verbindung mit Anspruch 5 oder 6, bei der das genannte aktivierende Signal das genannte Hilfsrücksetzsignal ($\phi_4$) ist.

**Revendications**

1. Circuit de mémoire statique comprenant:
plusieurs cellules de mémoire ($MC_0$, $MC_1$, ...) disposées suivant une matrice ayant des colonnes et des lignes, plusieurs lignes de mot ($WL_0$, $WL_1$, ...) connectées à des lignes respectives des cellules de mémoire,
un dispositif de sélection de ligne (RB, RD) connecté aux lignes de mot et destiné à appliquer un signal de sélection à l'une quelconque des lignes de mot qui est indiquée individuellement par un signal d'adresse de ligne ($RA_{IN}$) appliqué au dispositif de sélection de ligne,
plusieurs paires de lignes de bit (BL, $\overline{\text{BL}}$) connectéés aux colonnes respectives des cellules de mémoire, et
un dispositif de remise à l'état initial (CNG, DL, RG, $Q_1$, $Q_2$, $Q_3$), comprenant un dispositif générateur de signaux de remise à l'état initial (RG) destiné, à la suite d'un changement dudit signal d'adresse de ligne ($RA_{IN}$) au début d'une opération d'accès à une cellule, à créer un signal de remise à l'état initial ($\phi_{12}$) qui est utilisé pour la réalisation d'une opération d'égalisation des lignes de bit dans laquelle les potentiels respectifs des lignes de bit (BL, $\overline{\text{BL}}$) de l'une au moins des paires sont égalisés,
caractérisé par un dispositif à retard (DL) incorporé au dispositif de remise à l'état initial et destiné à retarder la formation du signal de remise à l'état initial ($\phi_{12}$) d'un temps prédéterminé ($t_d$) supérieur à la période nécessaire à la réalisation de l'opération d'accès à une cellule, à partir du moment du changement du signal d'adresse de ligne ($RA_{IN}$), le circuit étant tel que le signal de remise à l'état initial ($\phi_{12}$) est terminé à la suite du premier changement du signal d'adresse de ligne suivant l'expiration du temps prédéterminé, les potentiels des lignes de bit étant ainsi mis à l'état initial pour l'opération suivante d'accès à une cellule.

2. Circuit selon la revendication 1, dans lequel le dispositif de remise à l'état initial (CNG, DL, RG, $Q_1$, $Q_2$, $Q_3$) comporte en outre un circuit de détection de changement d'adresse (CNG) destiné détecter un changement du signal d'adresse de ligne ($RA_{IN}$) et à former un signal de détection de changement d'adresse ($\phi_0$) à la suite d'un tel changement, le signal de détection de changement d'adresse ($\phi_0$) étant transmis au dispositif à retard (DL) qui est destiné, après l'écoulement du temps prédéterminé suivant la réception du signal de détection de changement d'adresse ($\phi_0$), à créer un signal de retard ($\phi_{DL}$) destiné au dispositif générateur de signaux de remise à zéro (RG) après la réception duquel le dispositif générateur de signaux de remise à l'état initial (RG) crée le signal de remise à l'état initial ($\phi_{12}$).

3. Circuit selon la revendication 1 ou 2, ans lequel le dispositif de remise à l'état initial (CNG, DL, RG, $Q_1$, $Q_2$, $Q_3$) comporte en outre un dispositif supplémentaire générateur de signaux de remise à l'état initial (1, 2, 3, 4) qui, à la suite d'un changement quelconque de signal d'adresse de ligne apparaissant pendant le retard de la création du signal de remise à l'état initial ($\phi_{12}$), est destiné à créer un signal supplémentaire de remise à l'état initial ($\phi_2$) qui est utilisé pour l'exécution d'une opération d'égalisation des potentiels des lignes de bit.

4. Circuit selon la revendication 3, dans lequel le circuit supplémentaire générateur de signaux de remise à l'état initial (1, 2, 3, 4) comprend un dispositif supplémentaire à retard (1) connecté de manière qu'il reçoive le signal de remise à l'état initial ($\phi_{12}$) et destiné à transmettre ce signal, après un retard prédéterminé ($t_{d1}$), à un dispositif inverseur (2) incorporé audit dispositif supplémentaire générateur de signaux de remise à l'état initial (1, 2, 3, 4), le dispositif inverseur (2) étant destiné à inverser le signal retardé de remise à l'état initial ($\phi_{12}$), et
une porte ET (3) connectée de manière qu'elle reçoive le signal inversé de remise à l'état initial ($\phi_a$) et le signal de détection de changement d'adresse ($\phi_0$) et destinée à transmettre un signal de sortie destiné à un multivibrateur monostable (4) incorporé au dispositif supplémentaire générateur de signaux de remise à zéro (1, 2, 3, 4), ce multivibrateur (4) étant destiné, après réception du signal de sortie, à créer ledit signal supplémen-taire de remise à l'état initial ($\phi_2$).

5. Circuit selon l'une quelconque des revendications précédentes, dans lequel, lorsqu'un signal de validation d'écriture ($\overline{WE}$) est appliqué au circuit pendant une opération d'écriture, ledit dispositif de remise à l'état initial (CNG, DL, RG, $Q_1$, $Q_2$, $Q_3$) est destiné à former un signal auxiliaire de remise à l'état initial ($\phi_4$) qui est utilisé pour l'exécution d'une opération d'égalisation des potentiels des lignes de bit.

6. Circuit selon la revendication 5, dans lequel le dispositif de remise à l'état initial (CNG, DL, RG, $Q_1$, $Q_2$, $Q_3$) comporte en outre une porte ET (6) connectée de manière qu'elle reçoive le signal de validation d'écriture ($\overline{WE}$) et soit le signal de remise à l'état initial ($\phi_{12}$) soit le signal supplémentaire de remise à l'état initial ($\phi_2$), et destinée à transmettre un signal de sortie qui 2 constitue le signal auxiliaire de remise à l'état initial ($\phi_4$).

7. Circuit selon l'une quelconque des revendications précédentes, dans lequel ledit dispositif de remise à l'état initial (CNG, DL, RG, $Q_1$, $Q_2$, $Q_3$) comporte en outre plusieurs transistors de remise à l'état initial des lignes de bit ($Q_1$), chacun ayant un trajet de circulation d'un courant de charge, monté entre les lignes de bit (BL, $\overline{BL}$) d'une paire correspondante de lignes de bit, et une borne de commande connectée de manière qu'elle reçoive un signal d'activation.

8. Circuit selon la revendication 7, dans lequel le dispositif de remise à l'état initial (CNG, DL, RG, $Q_1$, $Q_2$, $Q_3$) comporte en outre des transistors de charge préalable de lignes de bit ($Q_2$, $Q_3$), ayant chacun un trajet de circulation d'un courant de charge connecté entre une extrémité d'une ligne de bit correspondante (BL, $\overline{BL}$) et une borne de sortie d'une alimentation, et ayant aussi une borne de commande connectée de manière qu'elle reçoive le signal d'activation.

9. Circuit selon la revendication 7 ou 8 lorsqu'elle dépend de la revendication 1 ou 2, dans lequel le signal d'activation est le signal de remise à l'état initial ($\phi_{12}$).

10. Circuit selon la revendication 7 ou 8, lorsqu'elle dépend de la revendication 3 ou 4, dans lequel le signal d'activation est une combinaison du signal de remise à l'état initial ($\phi_{12}$) avec le signal supplémentaire de remise à l'état initial ($\phi_2$).

11. Circuit selon la revendication 7 ou 8, lorsqu'elle dépend de la revendication 5 ou 6, dans lequel ledit signal d'activation est le signal auxiliaire de remise à l'état initial ($\phi_4$).

# Fig. 1

# Fig. 2

## Fig. 3

$C_1$ — $C_2$ — $C_3$

RA $_{IN}$

$\phi_0$

$\phi_{DL}$ — $t_d$ —

$\phi_1$ — $\phi_{11}$ — $t_0$ — $t_d$ — $\phi_{12}$ — $t_0$ —

$WL_0$

$\overline{BL}$
BL — BL — $\overline{BL}$

## Fig. 4

RA $_{IN}$ — $t_1$ — $t_2$

$\phi_0$

$\phi_1$ — $t_0$ — $t_d$ — $t_0$ —

$\phi_a$ — $t_{d1}$

$\phi_2$ — $t_0$ —

$\phi_3$ — $t_0$ — $t_0$ — $t_0$ —

## Fig. 5

## Fig. 6

## Fig. 7